# EUROPEAN PATENT APPLICATION

(11) **EP 4 576 165 A1**
(43) Date of publication of application: **25.06.2025**
(21) Application number: 23219072.8
(22) Date of filing: 21.12.2023
(51) Int. Cl.: H01L 21/02

(54) **A METHOD FOR GROWING EPITAXIAL LAYERS ON AN ENGINEERED SUBSTRATE**

(71) Applicant: Imec VZW, 3001 Leuven (BE)
(72) Inventor: Kunert, Ms. Bernardette, 3001 Leuven (BE); Mols, Mr. Yves, 3001 Leuven (BE); Alcotte, Reynald, 3001 Leuven (BE)
(74) Representative: Patent Department IMEC

(57) **Abstract**

On an engineered substrate (1) comprising a handle substrate (2), and a crystalline semiconductor top layer (4) bonded to the handle substrate (2), a second crystalline semiconductor layer (10) is produced by epitaxial growth on said top layer (4). The thermal expansion coefficients of the handle substrate and the top layer are significantly different from each other, so that the top layer is strained at the growth temperature. The composition of the second layer (10) is selected so that at said growth temperature, the second layer is essentially unstrained. This enables growing a device stack with the second layer forming the bottom layer of said stack, and wherein said bottom layer (10) can be grown above a critical thickness without exhibiting relaxation defects. This is true also for subsequent layers (101-105;201-206) of the stack, especially for layers exceeding a critical thickness, by selecting the composition of said layers in the same way as the bottom layer.

## Description

### Field of the Invention

The present invention is related to the fabrication of semiconductor devices on an engineered substrate.

### State of the art.

Engineered substrates in semiconductor fabrication are substrates composed of a handle substrate and a crystalline semiconductor layer bonded thereto and suitable as a seed layer for epitaxial growth of additional layers required for the fabrication of semiconductor devices. Various types of engineered substrates are known, for example comprising a III-V semiconductor layer bonded to a Si substrate.

The application of engineered substrates is particularly useful for the integration of III-V devices onto large-diameter substrates such as Si or Ge substrates. For example, III-V device fabrication on 200/300 mm large-diameter Si wafers enables access to mature Si foundries and helps reduce production costs. Additionally, it allows for the co-integration of III-V devices with Si-based functionalities using Silicon photonic or CMOS wafers.

A problem may arise however when thick epitaxially grown layers are formed on certain types of engineered substrates. This may be the case when there is a large difference between the thermal expansion coefficients of the handle substrate and the crystalline seed layer bonded to the handle substrate. In such cases, the seed layer may be highly strained at the epitaxial growth temperature of a layer grown on the seed layer. As a consequence, when the grown material has the same free-standing lateral lattice constant as the seed layer, said grown layer is also strained, which may lead to the formation of relaxation defects which can propagate through the epitaxially grown layer, when this layer exceeds a given critical thickness.

### Summary of the invention

The invention is related to a method in accordance with the appended claims. On an engineered substrate comprising a handle substrate and a crystalline semiconductor top layer bonded to the handle substrate, a second crystalline semiconductor layer is produced by epitaxial growth on said top layer. The thermal expansion coefficients of the handle substrate and the top layer are significantly different from each other, so that the top layer is strained at the growth temperature. The composition of the second layer is selected so that at said growth temperature, the second layer is essentially unstrained. This is done by selecting said composition so that the free-standing lateral lattice constant of the grown layer at the growth temperature essentially matches the lateral lattice constant of the strained top layer of the engineered substrate (i.e. the lateral lattice constant of the actual strained layer itself), at said growth temperature. This enables growing a device stack with the second layer forming the bottom layer of said stack, and wherein said bottom layer can be grown above a critical thickness without exhibiting relaxation defects. This is true also for subsequent layers of the stack, especially for layers exceeding a critical thickness, by selecting the composition of said layers in the same way as the bottom layer.

The invention is in particular related to a method for producing a bottom layer of a device stack on an engineered substrate, said substrate comprising a handle substrate, and a top layer bonded to the handle substrate, said top layer being a first crystalline semiconductor layer, wherein:
- the thermal expansion coefficient of the handle substrate is different from the thermal expansion coefficient of the first crystalline layer,
- the bottom layer is a second crystalline semiconductor layer produced by epitaxial growth directly on the first crystalline semiconductor layer, wherein said epitaxial growth is performed at a growth temperature,
- the first crystalline layer is strained at said growth temperature,
characterised in that the composition of the material of the second crystalline layer is selected so that the free-standing lateral lattice constant of the second crystalline layer at the growth temperature essentially matches the lateral lattice constant of the strained first crystalline layer at the growth temperature, so that the second crystalline layer is essentially unstrained at said growth temperature.

According to an embodiment, the composition of the second crystalline layer is selected by the following steps:
- determining a first composition that is suitable for epitaxially growing, at said growth temperature, an essentially unstrained layer formed of a material of said first composition on a bulk substrate formed of the material of the first crystalline layer,
- making one or more adjustments to the first composition, thereby obtaining the composition of the second crystalline layer.

According to an embodiment, said first composition is defined by a formula comprising multiple chemical elements characterised by respective percentage coefficients, and said one or more adjustments are made by one or more of the following actions:
- lowering or raising the percentage coefficient of a first chemical element of the first composition and compensating said lowering or raising by adjusting the percentage coefficient of a second chemical element of the first composition,
- lowering the percentage coefficient of a first chemical element of the first composition and adding an additional chemical element to the first composition, said additional element being characterized by a percentage coefficient that compensates said lowering of the percentage coefficient of the first chemical element.

According to an embodiment, further chemical elements are added to the composition of the second crystalline layer, for compensating a change in the material properties of said second crystalline layer as a consequence of said adjustment.

According to an embodiment, the method further comprises consecutively producing additional layers of the device stack on the bottom layer by epitaxial growth at respective growth temperatures, wherein the composition of said additional layers is selected so that the free-standing lateral lattice constant of each additional layer essentially matches the lateral lattice constant of the previous layer at the respective growth temperature.

According to an embodiment, the method further comprises producing consecutively additional layers of the device stack by epitaxial growth at respective growth temperatures, wherein, if the thickness of an additional layer exceeds a pre-defined critical thickness, the composition of said additional layer is selected so that the free-standing lateral lattice constant of said additional layer essentially matches the lateral lattice constant of the previous layer at the growth temperature of said additional layer.

According to an embodiment, the top layer is bonded to the handle substrate through a bonding layer. According to another embodiment, the top layer is bonded directly to the handle substrate.

### Brief description of the figures

Figure 1 illustrates a small portion of an engineered substrate as known in the prior art.
Figure 2a illustrates a detail of the engineered substrate, in the vicinity of the interfaces between the bonding layer and respectively the handle wafer and the crystalline top layer. Figure 2b illustrates the same interfaces at a higher temperature.
Figure 3 illustrates the creation of a relaxation defect and its propagation through a layer that is formed on the engineered substrate by epitaxial growth, in accordance with prior art methods. The propagation takes place at the growth temperature.
Figure 4 illustrates the formation of a layer by epitaxial growth on the engineered substrate in accordance with an embodiment of the invention.
Figure 5 illustrates a device stack obtainable by the method of the invention for producing a heterojunction bipolar transistor (HBT).
Figure 6 illustrates a device stack obtainable by the method of the invention for producing a separate confinement heterostructure multi-quantum well (SCH-MQW) laser diode.

### Detailed description of the invention

The above-described problems of presently known methods and the way in which the invention solves these problems will be described on the basis of a detailed example, without limiting the scope of the invention to this example.

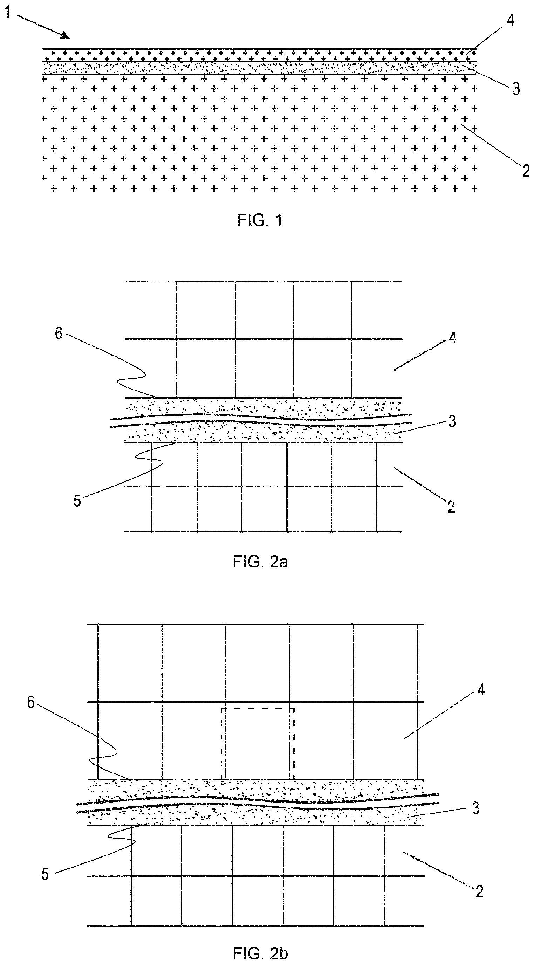

Figure 1 shows a top portion of an engineered substrate 1 as known in the prior art. The substrate 1 comprises a high resistivity Si handle wafer 2 which may be several hundreds of micrometres thick, a SiO₂ bonding layer 3 on the handle wafer and a crystalline indium phosphide (InP) layer 4 on the bonding layer 3. As known in the art, this type of engineered substrate can be produced by bonding a bulk InP substrate to the handle wafer 2 and thereafter splitting the thin InP layer 4 from the bulk wafer by the effect of a preliminary hydrogen ion implant in the bulk InP wafer. This method is known as the Smart Cut^{™} method. The engineered substrate 1 can be 100 mm in diameter for example. Larger InP-on-Si substrates can be produced by the same Smart Cut^{™} method after bonding multiple InP tiles to a large, for example 300 mm diameter Si handle wafer 2.

The thickness of the bonding layer 3 and of the InP layer 4 is about 200 nm in the represented example, but these layer thicknesses may vary between broader ranges known generally to the skilled reader. It is also possible to produce an InP-on-Si substrate wherein the InP layer 4 is directly bonded to the Si handle substrate 2, i.e. in that case there is no bonding layer 3.

This type of engineered substrate has been used for growing thereon a device stack, i.e. a stack of layers suitable for producing from said stack a semiconductor device such as a heterojunction bipolar transistor (HBT) or a separate confinement heterostructure multi-quantum (SCH-MQW) well laser diode. A particular problem arises however as a consequence of the significant difference between the thermal expansion coefficients of Si and InP. Respectively, the thermal expansion coefficients of these materials are about 2.6E-6/K and 4.6E-6/K. The formation of a bottom layer of a device stack by epitaxial growth on the InP layer 4 requires a high temperature, typically exceeding 600°C, applied for example in an MOVPE (Metal Organic Vapour Phase Epitaxy) reactor. The InP layer 4 is able to withstand these high temperatures without delamination or void formation due to the strong bond realized by the SiO₂ bonding layer 3 or by the direct InP to Si bond. This bonding layer 3 or said direct bond interlocks the crystal structures of both material systems, Si and InP, during bonding of the bulk InP wafer to the Si handle wafer 2, performed at low temperature, typically below 200°C.

However, as the epitaxial growth temperature is considerably higher than the bond temperature, the thermal expansion of the InP layer 4 exceeds the thermal expansion of the Si wafer 2, when a further layer is epitaxially grown at said growth temperature, on the InP layer 4. This is illustrated in Figures 2a and 2b. Figure 2a shows a simplified representation at room temperature of the crystal structures of the Si wafer 2 and of the InP layer 4, near the respective interfaces 5 and 6 between Si and InP with the SiO₂ bonding layer 3. Figure 2b illustrates what happens at a temperature applicable for epitaxial growth of an additional layer onto the InP layer 4. As the Si wafer 2 is much thicker than the InP layer 4, the Si crystals expand virtually uninhibited and in accordance with the thermal expansion coefficient of Si. The InP crystal structure however, by being bound to the Si crystal structure via the bonding layer 3 or by a direct bond, is constrained laterally and thereby unable to expand laterally in accordance with the higher expansion coefficient of InP. By consequence, the InP layer 4 becomes strained by a compressive stress. Figure 2b illustrates the unstrained expansion of one InP crystal in dotted lines. Compared to this, the InP crystals are constrained laterally and extended vertically.

In many practical applications, the bottom layer of a device stack produced on an engineered substrate is formed of the same material as the top layer 4 of the engineered substrate, i.e. it is often an InP layer in the case of a device stack grown on an InP-on-Si substrate, with the top InP layer 4 acting as the seed layer for the epitaxial growth. This may be done in an MOVPE reactor, to which constituent precursors of the required InP layer are supplied in a controlled atmosphere and at a required (high) growth temperature. According to the prior art, In and P are supplied at supply rates configured to grow InP on the InP layer 4 of the engineered substrate. A dopant element may be added in order to obtain p or n type doping of the grown layer.

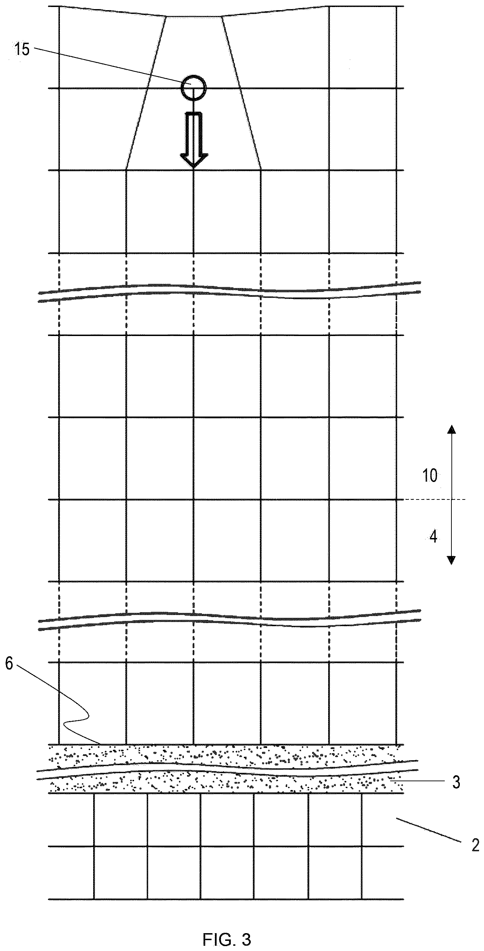

Figure 3 schematically illustrates the growth process for growing InP on the InP seed layer 4. Due to the nature of the epitaxial growth process, the grown layer 10 adapts to the lattice structure of the seed layer 4. Because the latter is strained at the growth temperature, the grown layer 10, which has the same free-standing lattice constant as the seed layer 4, is also strained at the growth temperature. When the thickness of the grown layer 10 remains below a given critical thickness, this build-up of strain is unlikely to lead to problematic defects. In that case, the layer is said to be pseudomorphically strained. However when the thickness exceeds the critical thickness, the strain buildup increases the risk of relaxation defects 15 which are typically nucleated at the growth surface and which are able to propagate through the layer 10 in the direction of the interface with the seed layer 4 and possibly through the seed layer itself, thereby deteriorating the performance and lifetime of the eventual device processed from the device stack.

According to the invention, the composition of the epitaxially grown crystalline layer that is grown directly on the top crystalline layer of an engineered substrate is selected so that the grown layer is essentially unstrained at the growth temperature. This is done by selecting said composition so that the free-standing lateral lattice constant of the grown layer at the growth temperature essentially matches the lateral lattice constant of the strained seed layer, at said growth temperature. The free-standing lateral lattice constant is the lateral lattice constant of a layer or substrate consisting of said crystalline material when the material is free of strain in any direction.

The composition of the epitaxially grown layer refers to the relative amounts of multiple chemical elements included in the lattice structure of the crystalline layer when said layer is in the solid state. This composition is commonly expressed in the form of a chemical formula comprising said elements, wherein each element is characterized by its respective percentage coefficient. For example, in the case of a III-V material such as indium phosphide, the formula InP is in fact the abbreviated form of In₁₀₀P₁₀₀ which considers 100% for group-III and 100% for group-V elements
Adding a small amount of gallium, which is a group-III element, is able to change the free-standing lateral lattice constant of the grown layer to essentially match the lateral lattice constant of the strained InP top layer of an engineered substrate at the growth temperature of the grown layer. The composition of the grown compound is defined by the formula: In₁₀₀₋ₓGaₓP₁₀₀, with x a small number, preferably between 1 and 5. The '100' is usually omitted if only one group element is listed, such as P (group V) in this particular example.

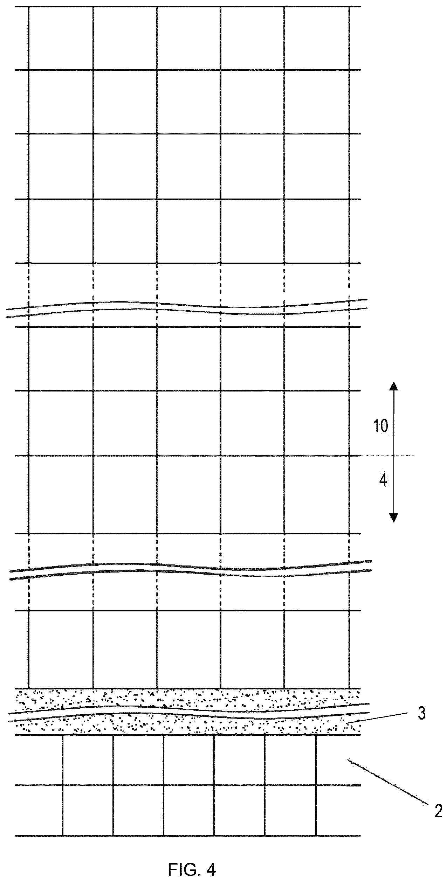

For example, by growing In_{98.4}Ga_{1.6}P on a strained InP layer, the grown layer is essentially unstrained at a growth temperature between 580°C and 600°C. This is illustrated in Figure 4. The grown layer 10 again adapts to the lateral lattice constant of the strained layer 4. However, as said lateral lattice constant essentially matches the free-standing lateral constant of the grown layer at the growth temperature, said grown layer 10 is essentially unstrained, and thereby able to grow to a considerable thickness without exhibiting relaxation defects. The addition of Ga can be done by adding a controlled supply of Ga precursor to the reactor during growth, in addition to the supply of In and P precursors, wherein the supply rate of In may be slightly reduced compared to the supply rate applied for growing a pure InP layer. If dopant elements are added during epitaxial growth, the supply rate thereof can be the same as the supply rates applied for growing a pure doped InP layer.

When it is stated herein that the free-standing lateral lattice constant of the grown layer essentially matches the lateral lattice constant of the strained top layer of the engineered substrate at the growth temperature, the term 'matches' may be interpreted as: said lateral lattice constants are equal or the difference between said lateral lattice constants is smaller than 0.1% of the lattice constant of the strained top layer of the engineered substrate at the growth temperature. According to further embodiments, said difference is smaller than 0.01%, smaller than 0.001%, or smaller than 0.0001% of the lattice constant of the strained top layer at the growth temperature.

The addition of the abovementioned small amount of Ga to an epitaxially grown InP layer does not significantly impact the material properties of the layer, so that such a layer can be used as a device layer of a semiconductor device processed on the engineered substrate. If the composition change does have a non-negligible impact on the material properties of the grown layer, such an impact may nevertheless be acceptable in terms of the operation of a device comprising part of the grown layer.

For example, when growing indium gallium arsenide on a bulk InP substrate, the composition that is most commonly used according to the prior art is defined by the formula In₅₃Ga₄₇As. By reducing the In content by between 2% and 5% and increasing the Ga content by the same amount, the grown layer is essentially unstrained at the growth temperature, when grown on an InP top layer of an engineered substrate as shown in Figure 1. The composition change may result in a minimal increase in the band gap energy of the adjusted layer, which is generally not critical for most device applications. If precise control over the band gap energy is necessary however, additional elements such as Sb or N can be added to meet both the band gap energy and lattice constant requirements simultaneously. An example of a suitable adjustment to the composition of indium gallium arsenide in that respect is the composition defined as In_{46.4}Ga_{53.6}As_{93.8}Sb_{6.2}.

The required composition changes, for example the value of x in the abovenamed compositions In₁₀₀₋ₓGaₓP can be determined by calculations based on known formulas, thermal expansion coefficients and on the knowledge of the growth temperature. The optimal composition may nevertheless slightly deviate from theoretically calculated values. Fine-tuning can be performed based on in situ curvature measurements during epitaxy or through X-ray diffraction measurements at room temperature after growth, by extrapolating the lateral lattice constant to the deposition temperature based on the thermal expansion coefficient.

The above examples illustrate an embodiment of a characterizing step of the method of the invention, namely the step of selecting the composition of the grown layer so as to be essentially unstrained at the growth temperature. According to this embodiment, an adjustment is made to a composition of a material that is suitable for epitaxially growing an essentially unstrained layer of said material on a bulk substrate formed of the material of the top layer. For example, for growing unstrained InP on a bulk InP substrate, the applicable composition is the standard InP, while for growing unstrained indium gallium arsenide on a bulk substrate, the applicable composition is In₅₃Ga₄₇As. According to the examples of the method of the invention described above, adjustments are made to these compositions, either by changing the content of the elements of the composition or by adding an element, said adjustments being selected so that the grown layer is essentially unstrained at the growth temperature, when grown, not on a bulk InP substrate, but on the top InP layer of an engineered substrate.

The 'selection' can however be made in other ways, i.e. not necessarily by starting from a composition that is applicable on a bulk substrate, and adjusting said composition. The selection could be made by starting from any other composition, or it could be composed independently from any particular starting composition.

A device stack produced on an engineered substrate comprises multiple layers formed consecutively on said substrate. According to the invention, the bottom layer of the device stack is formed by epitaxial growth in accordance with the above-described method so that the bottom layer is essentially unstrained at the growth temperature. According to preferred embodiments, the subsequent layers of the stack are equally formed in accordance with the invention, i.e. the composition of these layers is selected so that the free-standing lateral lattice constant of each layer essentially matches the lateral lattice constant of the previous layer at the respective growth temperatures of the additional layers. As all the layers of the stack adapt their lattice to the layers onto which they are grown, this means that the free-standing lateral lattice constants of the additional layers match the lateral lattice constant of the strained top layer 4 of the engineered substrate at the respective growth temperature of the additional layers, so that the additional layers are unstrained at the growth temperature. However, for very thin layers of the stack, the composition may be left unchanged compared to the composition of said thin layers used for the epitaxial growth of the stack on a bulk substrate. This is the case when said thin layers do not exceed a critical thickness above which the risk of defects becomes unacceptable. This critical thickness may slightly differ depending on the grown material and the base substrate material and on the growth temperature, but generally it lies below 100 nm for most semiconductor materials grown pseudomorphically strained.

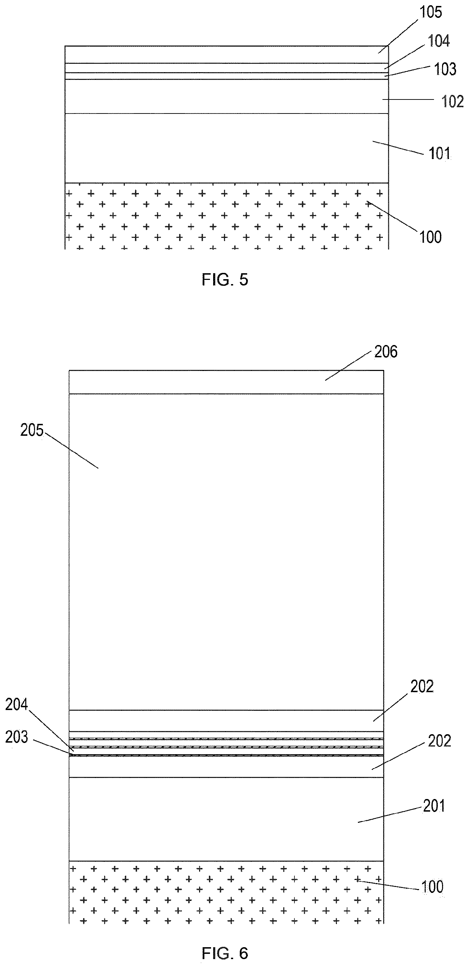

With reference to Figures 5 and 6, two examples are hereafter described of device stacks formed in accordance with the invention. Figure 5 shows a device stack suitable for forming a heterojunction bipolar transistor. The transistor is produced by processing the stack according to known processing methods. The stack is formed on a base substrate 100 and comprises a number of layers which are consecutively formed by epitaxial growth. The names of the layers and their thickness are shown in the first column of table 1 shown hereafter. The names refer to the constituent parts of the eventual HBT processed from the layer stack. The second column of table 1 shows the compositions of the various layers when the stack is formed on a bulk InP substrate, whereas the third column shows preferred compositions when the stack is formed in accordance with the method of the invention on an engineered substrate as illustrated in Figure 1. Doping levels are not indicated in the tables (also table 2). When two layers are consecutively grown with the same composition, these layers have a different doping level to differentiate the layers.

**Table 1: compared compositions of device layers for HBT on bulk InP and on engineered InP on Si substrate.**

| **Layer type and thickness** | **Composition on bulk InP substrate** | **Composition on InP-on-Si substrate** |
|---|---|---|
| Contact 105 - 100nm | In_{53.2}Ga_{46.8}As | In_{51.1}Ga_{48.9}As |
| Emitter 104 - 50nm | InP | In_{98.4}Ga_{1.6}P |
| Base 103 - 40nm | GaAs_{51.3}Sb_{48.7} | GaAs_{51.3}Sb_{48.7} or GaAs_{54.4}Sb_{45.6} |
| Collector 102 - 200nm | InP | In_{98.4}Ga_{1.6}P |
| Subcollector 101 - 400nm | InP | In_{98.4}Ga_{1.6}P |
| Substrate 100 | bulk InP wafer | InP-on-Si wafer |

As indicated in the table, the composition of the base layer 103 in the case of the engineered substrate may be unchanged compared to the standard composition applied on a bulk substrate, or it may be adapted to match the lattice of the collector layer 102 at the growth temperature. This is because the thickness of the base layer is below the critical thickness for the applied material GaAsₓSb₁₀₀₋ₓ.

Another example is illustrated in Figure 6 and table 2 hereafter. The device stack is suitable for producing a separate confinement heterostructure multi-quantum well (SCH-MQW) laser diode. The device stack comprises a sequence of 3 thin quantum well layers 203 interspaced with barrier layers 204. The other layer types and thicknesses are indicated in the first column of Table 2.

**Table 2 : compared compositions of device layers for SCH-MQW laser diode on bulk InP and on engineered InP on Si substrate.**

| **Layer type and thickness** | **Composition on bulk InP substrate** | **Composition on InP-on-Si substrate** |
|---|---|---|
| Contact 206 - 120nm | In₅₃Ga₄₇As | In_{51.1}Ga_{48.9}As |
| cladding 205 - 1500nm | InP | In_{98.4}Ga_{1.6}P |
| SCH layer 202 - 100nm | Ga_{20.9}In_{79.1}As_{45.4}P_{54.6} | Ga_{23.8}In_{76.2}As_{47.9}P_{52.1} |
| 3 X Barrier 204 - 30nm | Ga_{20.9}In_{79.1}As_{45.4}P_{54.6} | Ga_{23.8}In_{76.2}As_{47.9}P_{52.1} |
| 3 X QW 203 - 8nm | Ga₃₉In₆₁As₈₄P₁₆ | Ga_{43.2}In_{56.8}As_{88.3}P_{11.7} |
| SCH layer 202 - 100nm | Ga_{20.9}In_{79.1}As_{45.4}P_{54.6} | Ga_{23.8}In_{76.2}As_{47.9}P_{52.1} |
| Buffer 201 - 400nm | InP | In_{98.4}Ga_{1.6}P |
| Substrate 100 | bulk InP wafer | InP-on-Si wafer |

The band gaps of the laser diode layers grown on the InP-on-Si wafer are essentially unchanged compared to the layers grown on the bulk InP wafer. The composition of the QW layers 203 could be the same as the composition used on the bulk wafer, as the thickness of these layers is below the critical thickness. However, in that case, the strain in the QW layers would change the wavelength of the laser light, which would then require tuning the thickness of the QW layers. It may be preferred therefore to adjust the composition of the thin QW layers in accordance with the invention, so that these layers are essentially unstrained.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for producing a bottom layer (10) of a device stack on an engineered substrate (1), said substrate comprising a handle substrate (2), and a top layer (4) bonded to the handle substrate (2), said top layer being a first crystalline semiconductor layer, wherein:
- the thermal expansion coefficient of the handle substrate (2) is different from the thermal expansion coefficient of the first crystalline layer (4),
- the bottom layer (10) is a second crystalline semiconductor layer produced by epitaxial growth directly on the first crystalline semiconductor layer, wherein said epitaxial growth is performed at a growth temperature,
- the first crystalline layer (4) is strained at said growth temperature,
**characterised in that** the composition of the material of the second crystalline layer (10) is selected so that the free-standing lateral lattice constant of the second crystalline layer (10) at the growth temperature essentially matches the lateral lattice constant of the strained first crystalline layer (4) at the growth temperature, so that the second crystalline layer (10) is essentially unstrained at said growth temperature.

2. The method according to claim 1, wherein the composition of the second crystalline layer (10) is selected by the following steps:
- determining a first composition that is suitable for epitaxially growing, at said growth temperature, an essentially unstrained layer formed of a material of said first composition on a bulk substrate formed of the material of the first crystalline layer (4),
- making one or more adjustments to the first composition, thereby obtaining the composition of the second crystalline layer (10).

3. The method according to claim 2, wherein said first composition is defined by a formula comprising multiple chemical elements **characterised by** respective percentage coefficients, and wherein said one or more adjustments are made by one or more of the following actions:
- lowering or raising the percentage coefficient of a first chemical element of the first composition and compensating said lowering or raising by adjusting the percentage coefficient of a second chemical element of the first composition,
- lowering the percentage coefficient of a first chemical element of the first composition and adding an additional chemical element to the first composition, said additional element being **characterized by** a percentage coefficient that compensates said lowering of the percentage coefficient of the first chemical element.

4. The method according to claim 2 or 3, wherein further chemical elements are added to the composition of the second crystalline layer (10), for compensating a change in the material properties of said second crystalline layer as a consequence of said adjustment.

5. The method according to any one of the preceding claims, further comprising consecutively producing additional layers (102-105;202-206) of the device stack on the bottom layer (101,201) by epitaxial growth at respective growth temperatures, wherein the composition of said additional layers is selected so that the free-standing lateral lattice constant of each additional layer essentially matches the lateral lattice constant of the previous layer at the respective growth temperature.

6. The method according to any one of claims 1 to 4, further comprising consecutively producing additional layers (101-105;201-206) of the device stack by epitaxial growth at respective growth temperatures, wherein, if the thickness of an additional layer exceeds a pre-defined critical thickness, the composition of said additional layer is selected so that the free-standing lateral lattice constant of said additional layer essentially matches the lateral lattice constant of the previous layer at the growth temperature of said additional layer.

7. The method according to any one of the preceding claims, wherein the top layer (4) is bonded to the handle substrate (2) through a bonding layer (3).

8. The method according to any one of claims 1 to 6, wherein the top layer (4) is bonded directly to the handle substrate (2).
